# EUROPEAN PATENT APPLICATION

(11) **EP 2 693 503 A1**
(43) Date of publication of application: **05.02.2014**
(21) Application number: 12179323.6
(22) Date of filing: 03.08.2012
(51) Int. Cl.: H01L 51/42, H01G 9/20

(54) **Organo metal halide perovskite heterojunction solar cell and fabrication thereof**

(71) Applicant: Ecole Polytechnique Fédérale de Lausanne (EPFL), 1015 Lausanne (CH)
(72) Inventor: Lioz, Etgar, 1012 Lausanne (CH); Nazeeruddin, MD. Khaja, 1024 Ecublens (CH); Graetzel, Michael, 1025 St-Sulpice (CH)
(74) Representative: Ganguillet, Cyril

(57) **Abstract**

The present invention provides a solid state heterojunction solar cell comprising a transparent conducting support layer, on which a nanostructured, surface-increasing scaffold structure is provided, wherein an organic-inorganic perovskite layer is provided on said scaffold structure, and wherein a counter electrode and/or metal layer is provided in electric contact with said perovskite layer. According to an embodiment, the solar cell lacks an electrolyte or any hole conducting material. The invention also relates to a solid state heterojunction and to a method of preparing the solar cell.

## Description

### Technical Field

The present invention relates to a solid state solar cell, to a heterojunction, and to methods of preparing the solar cell.

### Technical Background and the Problem Underlying the Invention

Quantum dots (QDs) have attracted a lot of attention due to their tunable band gap and their high optical absorption cross section. ¹⁻³ A variety of research projects attempt to integrate QDs into solar cells devices, including nanocrystal (NC)-polymer hybrid solar cells, NC-Schottky solar cells, NC-sensitized titanium dioxide (TiO₂) solar cells, and NC hybrid bilayer solar cells. ⁴⁻¹² Recently investigations focus on QDs heterojunction solar cells, by placing oxide NCs (TiO₂ or ZnO) as a thin spacer layer between the QDs and the FTO, efficiencies of 5-6% were observed using those hetrojunction structures. ¹³⁻²¹ In addition, a tandem QDs solar cell with the same structure has been demonstrated. ²² Multiple exciton generation (MEG) effect was also demonstrated in a similar QDs based solar cell structure.²³ This heterojunction QDs solar cell showed promising photovoltaic performance, however it is still has to face several problems which prevent from them to achieve higher efficiencies such us: stability, low open circuit voltage and recombination issues.

The present invention addresses disadvantages of devices comprising liquid electrolytes, such as the problem of solvent evaporation and the penetration of water into the solar cell caused by difficulty in long-term sealing especially in temperature cyclic tests.

The present invention also addresses disadvantages of devices comprising organic hole conductor materials, such as the incomplete pore filling which is observed with such hole conductors. In particular, the hole conductor tends not to penetrate equally through the mesoporous film of sensitized solar cells using a porous semiconductor anode, for example. Furthermore, the present invention addresses the problem of oxidization of the hole conductor. Oxidation of the hole conductor may cause stability problems and lack of consistency. Furthermore, the present invention addresses the problem of low hole mobility observed with conductors used in the prior art, which are low compared to liquid electrolytes.

The invention seeks to provide an efficient solar cell that can be prepared rapidly in an efficient way, using readily available, low-cost materials, using a short manufacturing procedure based on industrially known manufacturing steps.

The present invention addresses the problems of stability observed with certain sensitized solar cells.

### Summary of the Invention

Remarkably, the present inventors provided novel solid state solar cells. The solar cells differ from previously known solar cells, in particular by way of their simple structure. The novel solar cells generally comprise readily available materials and can be fabricated in an economic manner. The novel solar cell can avoid disadvantages associated with the use of electrolytes or hole transporting materials.

In an aspect, the present invention provides a solid-state solar cell comprising a conducting support layer and a surface-increasing scaffold structure, wherein one or more organic-inorganic perovskite layer is provided on said scaffold structure or on an optional protective layer provided on said scaffold structure, and wherein a counter electrode and/or metal layer is provided in electric contact with said perovskite layer.

In an aspect, the present invention provides a solid-state solar cell comprising a conducting support layer and a nanostructured scaffold layer, wherein one or more organic-inorganic perovskite layer is provided on said scaffold layer or on an optional protective layer provided on said scaffold structure, and wherein a counter electrode and/or metal layer is provided in electric contact with said perovskite layer.

In an aspect, the present invention provides a solid state heterojunction comprising a conducting support layer, on which a surface-increasing scaffold structure is provided, wherein an organic-inorganic perovskite layer is provided on said scaffold structure or on an optional protective layer provided on said scaffold structure.

In a further aspect, the invention provides a solar cell comprising the heterojunction of the invention.

In an aspect, the present invention provides a method of preparing a solid state solar cell, the method comprising the steps of:
- providing a conducting support layer on which a surface-increasing scaffold structure is provided;
- applying one or more organic-inorganic perovskite layer on said scaffold structure or on a protective layer that may be provided on said scaffold structure; and,
- applying a counter electrode.

In an aspect, the present invention provides a method of preparing a solid state solar cell, the method comprising the steps of:
- providing a conducting support layer on which a surface-increasing nanostructured scaffold layer;
- applying one or more organic-inorganic perovskite layer on said scaffold structure or on a protective layer that may optionally be provided on said scaffold structure; and,
- applying a counter electrode.

In an aspect, the present invention provides a method of preparing a heterojunction comprising the step of applying one or more organic-inorganic perovskite layers on a nanostructured scaffold layer.

Further aspects and preferred embodiments of the invention are defined herein below and in the appended claims. Further features and advantages of the invention will become apparent to the skilled person from the description of the preferred embodiments given below.

### Brief Description of the Drawings

**Figure 1** schematically represents the device structure of a solar cell according to an embodiment of the present invention (A) and an energy level diagram of a solar cell based on a CH₃NH₃PbI₃/TiO₂ heterojunction (B) according to an embodiment of the invention.
**Figure 2** is an image obtained by electron microscopy showing a cross section of an organo lead halide perovskite heterojunction solar cell prepared in the examples below in accordance with an embodiment of the present invention.
**Figure 3** shows J-V characteristic of the Lead iodide perovskite/TiO₂ heterojunction solar cell (A) and the IPCE spectrum of the device (B).

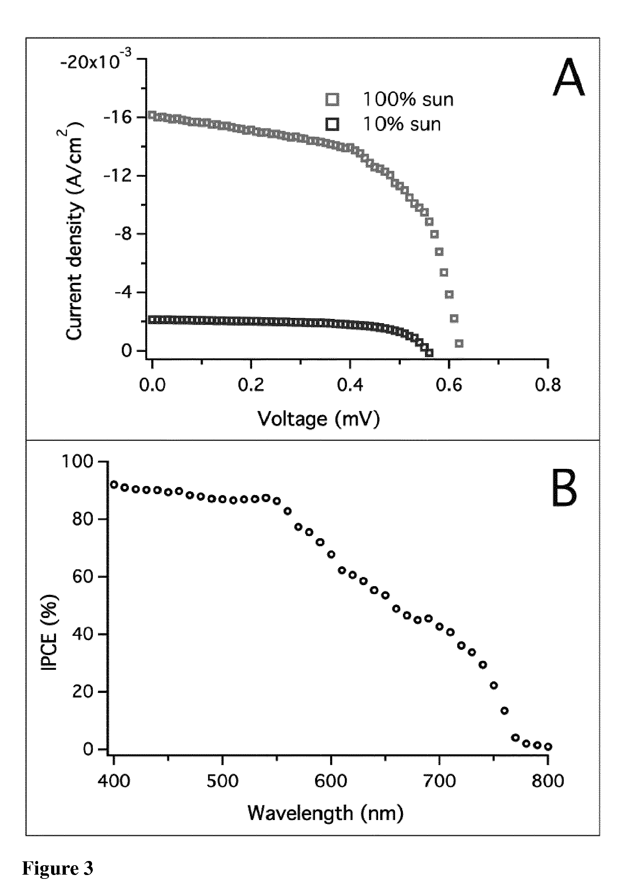

**Figure 3** schematically shows an organic-inorganic perovskite structure used in accordance with an embodiment of the invention and possible energy-level schemes A or B that can arise within these structures.

### Detailed Description of the Preferred Embodiments

The present invention provides heterojunctions, solar cells and methods of fabricating the heterojunction and the solar cell. The heterojunction of the invention may be used in a solar cell, in particular in the solar cell of the invention. Herein below, the solar cell comprising such a heterojunction and its fabrication are described in more detail.

According to an embodiment, the solar cell of the invention preferably comprises a conducting support layer, on which a surface-increasing scaffold structure is preferably provided, wherein an organic-inorganic perovskite layer is preferably provided on said scaffold structure, and wherein a counter electrode and/or metal layer is provided in electric contact with said perovskite layer. According to an embodiment, the conducting support layer, the scaffold structure, the perovskite layer and the counter electrode are present in this order from one side to the other of the solar cell of the invention. Protective layers and/or hole transport layers may or may not be present, for example at appropriate positions between the above layers, as disclosed elsewhere in this specification.

The solar cell of the invention preferably comprises a conducting support layer. The conducting support layer is preferably substantially transparent. "Transparent" means transparent to at least a part, preferably a major part of the visible light. Preferably, the conducting support layer is substantially transparent to all wavelengths or types of visible light. Furthermore, the conducting support layer may be transparent to non-visible light, such as UV and IR radiation, for example.

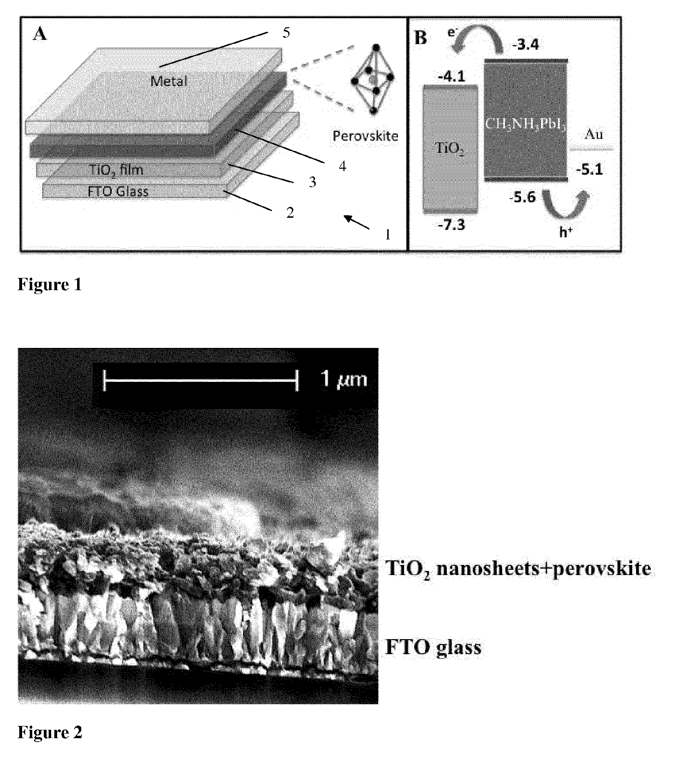

According to an embodiment, the conducting support layer provides the support layer of the solar cell of the invention. Preferably, the solar cell is built on said support layer. According to another embodiment, the support of the solar cell is provided on the side of the counter electrode. In this case, the conductive support layer (no 1 in Fig. 1) does not necessarily provide the support of the device, but may simply be or comprise a current collector, for example a metal foil.

The conducting support layer preferably functions and/or comprises a current collector, collecting the current obtained from the solar cell.

For example, the conducting support layer may comprise a material selected from indium doped tin oxide (ITO), fluorine doped tinoxide (FTO), ZnO-Ga₂O₃, ZnO-Al₂O₃, tin-oxide, antimony doped tin oxide (ATO), SrGeO₃ and zinc oxide, preferably coated on a transparent substrate, such as plastic or glass. In this case, the plastic or glass provides the support structure of the layer and the cited conducting material provides the conductivity. Such support layers are generally known as conductive glass and conductive plastic, respectively, which are thus preferred conducting support layers in accordance with the invention. According to an embodiment, the conducting support layer comprises a conducting transparent layer, which may be selected from conducting glass and from conducting plastic.

The current collector may also be provided by a conductive metal foil, such as a titanium or zinc foil, for example. Non-transparent conductive materials may be used as current collectors in particular on the side of the device that is not exposed to the light to be captured by the device. Such metal foils have been used, for example, in flexible devices, such as those disclosed by Seigo Ito et al., Chem. Commun. 2006, 4004-4006.

According to an embodiment of the invention, a surface-increasing scaffold structure is provided on said conducting support structure or on a protective layer that may be provided on said scaffold structure.

According to an embodiment of the solar cell and the heterojunction of the invention, the surface-increasing scaffold structure is nanostructured and/or nanoporous. The scaffold structure is thus preferably structured on a nanoscale. The structures of said scaffold structure increase the effective surface compared to the surface of the conductive support.

The scaffold material may be made from any one or combinations selected from of a large variety of different materials. According to an embodiment, the surface-increasing scaffold structure of the solar cell and/or the heterojunction of the invention comprises, consists essentially of or is made from one selected from the group consisting of a semiconductor material, a conducting material, a non-conducting material and combinations of two or more of the aforementioned.

According to an embodiment, said scaffold structure is made from and/or comprises a metal oxide. For example, the material of the scaffold structure is selected from semiconducting materials, such as Si, TiO₂, SnO₂, Fe₂O₃, ZnO, WO₃, Nb₂O₅, CdS, ZnS, PbS, Bi₂S₃, CdSe, CdTe, SrTiO₃, GaP, InP, GaAs, CuInS₂, CuInSe₂, and combinations thereof, for example. Preferred semiconductor materials are Si, TiO₂, SnO₂, ZnO, WO₃, Nb₂O₅ and SrTiO₃, for example.

However, the material of the scaffold structure does not need to be semiconducting or conducting, but could actually be made from a non-conducting and/or insulating material. For example, the scaffold structure could be made from plastics, for example from plastic nanoparticles, which are in any way assembled on the conducting support and are fixed thereon, for example by heating and/or cross-linking. Polystyrene (PS) spheres of sub-micrometer size deposited on a conducting substrate can be cited as an example of a non-conducting scaffold structure.

In case the scaffold structure is made from and/or comprises a non-conducting material, an electric connection between the following layer, for example the perovskite layer and the conducting support should be warranted. This may be achieved, for example, by allowing the perovskite layer being in direct contact with the conductive support, or, if present, with the protective layer, which may be provided on the conductive support and/or on the scaffold structure. In this regard, it is noted that the scaffold structure does not necessarily have to form a layer that covers the conductive support surface completely. The scaffold may be formed by nanoparticles that are applied on the conductive support, wherein said conductive support does not need to be covered completely.

One can also envisage a non-conducting scaffold structure, which is coated with a layer of an electrically conducting and/or semiconducting material. The coating is sufficiently thin so as to substantially retain the original nanostructured and/or nanoporous structure of the scaffold structure. For example, the electrically conducting and/or semiconducting coating may be in electric contact with said conductive support. The protective layer discussed elsewhere in this specification can be cited as a non-limiting example of a thin layer that may be applied on the scaffold structure.

Finally, the scaffold structure can also be made from a conducting material, for example from a metal and/or from conducting polymers, for example.

According to an embodiment, the surface-increasing scaffold structure of the solar cell and/or heterojunction of the invention comprises nanoparticles, which are applied and/or fixed on said support layer. The expression "nanoparticles" encompasses particles, which may have any form, in particular also so-called nanosheets. Nanosheets made from anatase TiO₂ have been reported by Etgar et al., Adv. Mater. 2012, 24, 2202-2206.²⁰

The scaffold structure may also be prepared by screen printing or spin coating, for example as is conventional for the preparation of porous semiconductor (e.g. TiO2) surfaces in dye-sensitized solar cells, see for example, Thin Solid Films 516, 4613-4619 (2008) or Etgar et al., Adv. Mater. 2012, 24, 2202-2206. Nanoporous semiconductor structures and surfaces have been disclosed, for example, in EP 0333641 and EP 0606453.

According to an embodiment of the invention, said scaffold structure comprises and/or is prepared from nanoparticles, in particular nanosheets, which nanoparticleas and/or nanosheets are preferably further annealed. The nanoparticles preferably have dimensions and/or sizes in the range of 2 to 300 nm, preferably 3 to 200 nm, even more preferably 4 to 150 nm, and most preferably 5 to 100 nm. "Dimension" or "size" with respect to the nanoparticles means here maximum extensions in any direction of space, including the diameter in case of substantially spherical or ellipsoid particles, or length and thickness in case of nanosheets. Preferably, the size of the nanoparticles is determined by transmission electron microscopy (TEM) and selected area electron diffraction (SAED) as disclosed by Etgar et al_{.} ²⁰

According to an embodiment, the surface-increasing scaffold structure is nanostructured and/or nanoporous.

According to an embodiment, the surface area per gram ratio of said scaffold structure is in the range of 20 to 200 m²/g, preferably 30 to 150 m²/g, and most preferably 60 to 120 m²/g. The surface per gram ratio may be determined the BET gas adsorption method.

According to an embodiment, said scaffold structure forms a continuous and/or complete, or, alternatively, a non-continuous and/or non-complete layer on said support layer. According to an embodiment, said scaffold structure forms a layer having a thickness of 10 to 2000 nm, preferably 15 to 1000 nm, more preferably 20 to 500 nm, still more preferably 50 to 400 nm and most preferably 100 to 300 nm. For the purpose of this specification, a "continuous layer" or a "complete layer" is a layer that covers the conductive support completely so that there can be no contact between the perovskite layer (or, if applicable, the protective layer) and the conductive support. If the scaffold layer is non-continuously and/or non-completely provided on said conductive support layer, the perovskite layer could get in direct contact with said conductive support layer. However, one can envisage a further layer between a, for example, non-continuous, scaffold layer and the conductive support layer, for example a protective layer as disclosed elsewhere in this specification. In this case, a direct contact of the perovskite layer and the conductive support is avoided.

According to a preferred embodiment, the surface-increasing scaffold structure is provided on said conducting support layer. However, the invention does not intend to exclude the possibility that there is one or more intermediate layers between the scaffold structure and the conductive support. Such intermediate layers, if present, would preferably be conducting and/or semiconducting.

According to an embodiment, the heterojunction and/or solar cells of the invention comprise an organic-inorganic perovskite layer. The heterojunction and/or solar cell may comprise one or more layers, which may each be the same or different.

"Perovskite", for the purpose of this specification, refers to the "perovskite structure" and not specifically to the perovskite material, CaTiO₃. For the purpose of this specification, "perovskite" encompasses and preferably relates to any material that has the same type of crystal structure as calcium titanium oxide and of materials in which the bivalent cation is replaced by two separate monovalent cations. The perovskite structure has the general stoichiometry AMX3, where "A" and "M" are cations and "X" is an anion. The "A" and "M" cations can have a variety of charges and in the original Perovskite mineral (CaTiO3), the A cation is divalent and the M cation is tetravalent. For the purpose of this invention, the perovskite formulae includes structures having three (3) or four (4) anions, which may be the same or different, and/or one or two (2) organic cations, and/or metal atoms carrying two or three positive charges, in accordance with the formulae presented elsewhere in this specification.

Organic-inorganic perovskites are hybrid materials exhibiting combined properties of organic composites and inorganic crystalline. The inorganic component forms a framework bound by covalent and ionic interactions which provide high carrier mobility. The organic component helps in the self-assembly process of those materials, it also enables the hybrid materials to be deposited by low-cost technique as other organic materials. Additional important property of the organic component is to tailor the electronic properties of the organic-inorganic material by reducing its dimensionality and the electronic coupling between the inorganic sheets.

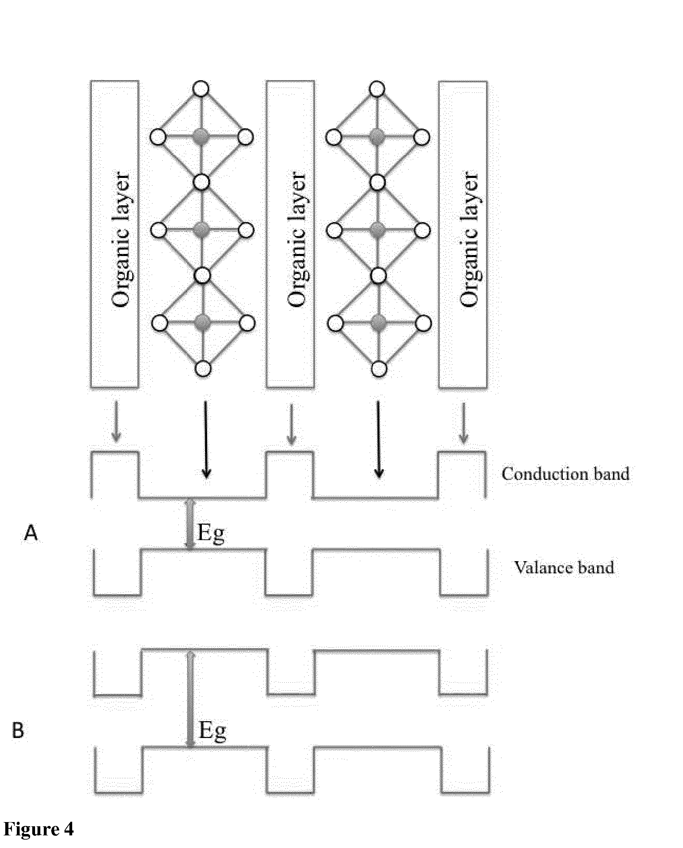

The structure of the organic-inorganic perovskites are analogous to multilayer quantum well structures, with semiconducting inorganic sheets alternating with organic layers having a large energy gap (Figure 4). Fig. 4A shows one possibility when the conduction band of the inorganic layers is substantially below that of the organic layers, and the valence band of the inorganic layers is similarly above that of the organic layers. Therefore, the inorganic sheets act as quantum wells for both electrons and holes.

Another option is when the bandgaps for the organic and inorganic layers can be offset as illustrated in Fig. 4B, leading to a type II heterostructure in which the wells for the electrons and holes are in different layers.

Those structures of the organic-inorganic perovskites permit their use as sensitizer, which can inject electrons to the scaffold structure and/or the conductive support and at the same time may function as hole conductor.

The organic-inorganic perovskite material that is used in the one or more perovskite layer preferably has a molecular structure corresponding to any one of the formulae (I), (II), (III), and/or (IV) below:

A₂MX₄ (I)

AMX₃ (II)

ANX₄ (III)

BMX₄ (IV)

wherein A is an monovalent organic cation and B is a bivalent organic cation. Preferably, A and B are selected from hydrocarbons comprising up to 15 carbons, and from 1 to 20 heteroatoms (for A) and 2 to 20 heteroatoms (for B), in particular one or two positively charged nitrogen atoms, respectively, besides possibly further heteroatoms selected from N, O and S. Furthermore, A and B may be partially or totally halogenated, independently of said 1 to 20 heteroatoms.
M is a metal atom, which may be selected from the group consisting of Cu²⁺, Ni²⁺, Co²⁺, Fe²⁺, Mn²⁺ Cr²⁺, Pd²⁺, Cd²⁺, Ge²⁺, Sn²⁺, Pb²⁺, Eu²⁺, or Yb²⁺. Preferably, M is Sn²⁺ or Pb²⁺. N is a trivalent metal, which is preferably selected from the group of Bi³⁺ and Sb³⁺.
X is an anionic compound, and is preferably selected independently from Cl⁻, Br⁻, I⁻, NCS⁻, CN⁻, NCO⁻, and combinations thereof. As there may be three X in formulae (II), the perovskite material may comprise combinations of different halogens. For example, "X₃" may be selected from I₂Cl⁻³, IBr⁻³, Cl₂I⁻³, Br₂I⁻³, for example. The four anions in "X₄" may also be a combination of different halogens. Preferably, X is Br⁻ or I⁻.

According to a preferred embodiment, all anions in "X₃" and "X₄" are identical.

According to a preferred embodiment, said organic-inorganic perovskite layer comprises a perovskite-structure of the formula (I), (II), (III) and/or (IV) below,

A₂MX₄ (I)

AMX₃ (II)

ANX₄ (III)

BMX₄ (IV)

wherein,
A is an organic, monovalent cation selected from primary, secondary, tertiary or quaternary organic ammonium compounds, including N-containing heterorings and ring systems, A having from 1 to 15 carbons and 1 to 20 heteroatoms;
B is an organic, bialent cation selected from primary, secondary, tertiary or quaternary organic ammonium compounds having from 1 to 15 carbons and 2-20 heteroatoms and having two positively charged nitrogen atoms;
M is a divalent metal cation selected from the group consisting of Cu²⁺, Ni²⁺, Co²⁺, Fe²⁺, Mn²⁺, Cr²⁺, Pd²⁺, Cd²⁺, Ge²⁺, Sn²⁺, Pb²⁺, Eu²⁺, or Yb²⁺;
N is selected from the group of Bi³⁺ and Sb³⁺; and,
the three or four X are independently selected from I⁻, Br⁻, I⁻, NCS⁻, CN⁻, and NCO⁻.

M and N are preferably metal ions that can preferably adopt an octahedral anion coordination.

Preferably, X are selected from Br⁻ and I⁻, and M is Sn²⁺ or Pb²⁺.

According to a preferred embodiment, the perovskite material has the structure selected from one or more of formulae (I) to (III), preferably (II).

According to a preferred embodiment, said organic-inorganic perovskite layer (4) comprises a perovskite-structure of any one of the formulae (V), (VI), (VII), (VIII), (IX) and (X);

APbX₃ (V)

ASnX₃ (VI)

A₂PbX₄ (VII)

A₂SnX₄ (VIII)

BPbX₄ (IX)

BSnX₄ (X)

wherein A, B and X are as defined elsewhere in this specification. Preferably, X is selected from Br⁻ and I⁻, most preferably X is I⁻.

According to a preferred embodiment, said organic-inorganic perovskite layer comprises a perovskite-structure of the formulae (V) to (VIII), more preferably (V) and/or (VI) above.

According to an embodiment, A, in particular in any one of formulae (I) to (III), and (V) to (VIII), is a monovalent cation selected from any one of the compounds of formulae (1) to (8) below: 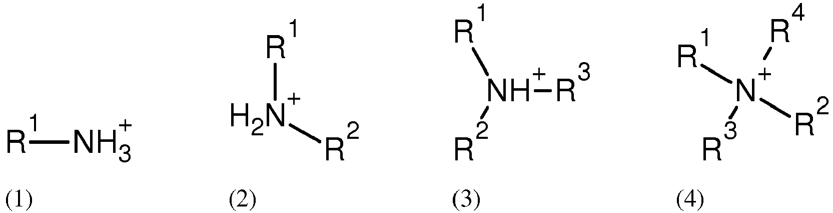 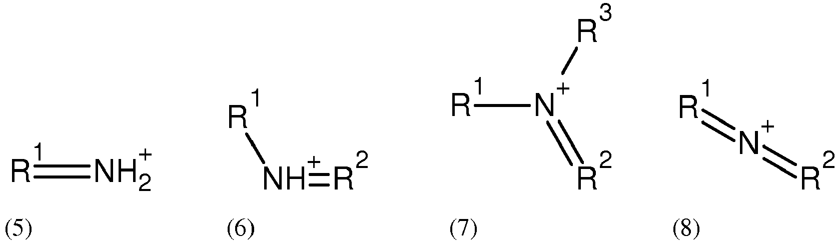 wherein,
any one of R¹, R², R³ and R⁴ is independently selected from C1 to C15 aliphatic and C4 to C15 aromatic substituents, wherein any one, several or all hydrogens in said substituent may be replaced by halogen and wherein, if there are two or more carbons, up to half of said carbons in said substituents may be replaced by a N, S or O heteroatom, and wherein, in any one of the compounds (2) to (8), the two or more of substituents present (R¹, R², R³ and R⁴, as applicable) may be covalently connected to each other to form a substituted or unsubstituted ring or ring system.

According to an embodiment, B is a bivalent cation selected from any one of the compounds of formulae (9) and (10) below: 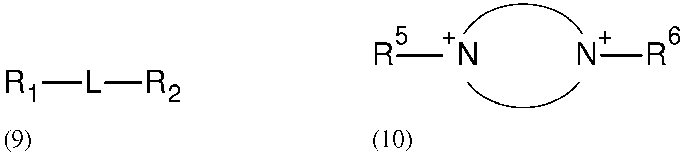 wherein,
in the compound of formula (9), L is absent or an aliphatic or aromatic linker structure having 1 to 10 carbons, wherein any one, several or all hydrogens in said L may be replaced by halogen and wherein up to half of the carbons in said L may be replaced, independently, by a N, S or O heteroatom;
wherein any one of R₁ and R₂ is independently selected from any one of the substituents (20) to (25) below: 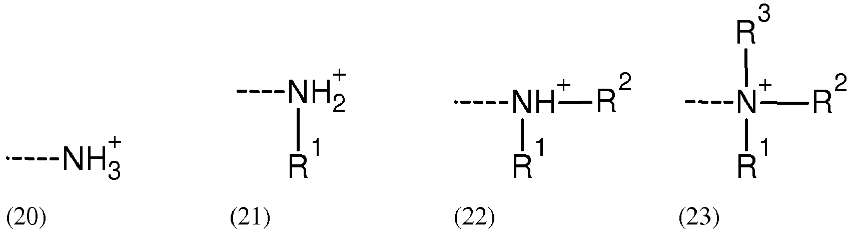 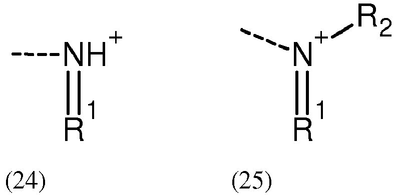 wherein the dotted line in the substituents (20) to (25) represents the bond by which said substituent is connected to the linker structure L;
wherein R¹, R², and R³ are independently as defined above with respect to the compounds of formulae (1) to (8);
wherein R₁ and R₂, if they are both different from substituent (20), may be covalently connected to each other by way of their substituents R¹, R², and R³, as applicable, and wherein any one of R¹, R², and R³, if present, may be covalently connected to L or the ring structure of compound (10), independently from whether said substituent is present on R₁ or R₂;
and wherein, in the compound of formula (10), the circle containing said two positively charged nitrogen atoms represents an aromatic ring or ring system comprising 4 to 15 carbon atoms and 2 to 7 heteroatoms, wherein said nitrogen atoms are ring heteroatoms of said ring or ring system, and wherein the remaining of said heteroatoms may be selected independently from N, O and S and wherein R⁵ and R⁶ are independently selected from H and from substituents as R¹ to R⁴. Halogens substituting hydrogens totally or partially may also be present in addition to said 2 to 7 heteroatoms.

If L is absent, said substituents R₁ and R₂ are directly connected, forming an N-N bond, as illustrated by compound (34) below.

Preferably, if the number of carbons is in L is impair, the number of heteroatoms is smaller than the number of carbons. Preferably, in the ring structure of formula (10), the number of ring heteroatoms is smaller than the number of carbon atoms.

According to an embodiment, in the compound of formula (9), L is an aliphatic or aromatic linker structure having 1 to 8 carbons, wherein any one, several or all hydrogens in said L may be replaced by halogen and wherein 0 to 4 carbons in said L may be replaced, independently, by a N, S or O heteroatom. Preferably, L is an aliphatic or aromatic linker structure having 1 to 6 carbons, wherein any one, several or all hydrogens in said L may be replaced by halogen and wherein 0 to 3 carbons in said L may be replaced, independently, by a N, S or O heteroatom.

According to an embodiment, in the compound of formula (9), said linker L is free of any O or S heteroatoms. According to an embodiment, L is free of N, O and/or S heteroatoms.

According to an embodiment, in the compound of formula (10), the circle containing said two positively charged nitrogen atoms represents an aromatic ring or ring system comprising 4 to 10 carbon atoms and 2 to 5 heteroatoms (including said two ring N-atoms).

According to an embodiment, said ring or ring system in the compound of formula (10) is free of any O or S heteroatoms. According to an embodiment, said ring or ring system in the compound of formula (10) is free of any further N, O and/or S heteroatoms, besides said two N-ring atoms. This does not preclude the possibility of hydrogens being substituted by halogens.

As the skilled person will understand, if an aromatic linker, compound, substituent or ring comprises 4 carbons, it comprises at least 1 ring heteroatom, so as to provide said aromatic compound.

According to an embodiment, any one of R¹, R², R³ and R⁴ is independently selected from C1 to C8 aliphatic and C4 to C8 aromatic substituents wherein any one, several or all hydrogens in said substituent may be replaced by halogen and wherein, if there are two or more carbons, up to half of said carbons in said substituents may be replaced by a N, S or O heteroatom, and wherein two or more of substituents present on the same cation may be covalently connected to each other to form a substituted or unsubstituted ring or ring system.

According to an embodiment, any one of R¹, R², R³ and R⁴ is independently selected from C1 to C6 aliphatic and C4 to C6 aromatic substituents wherein any one, several or all hydrogens in said substituent may be replaced by halogen and wherein, if there are two or more carbons, up to half of said carbons in said substituents may be replaced by a N, S or O heteroatom and wherein two or more of substituents present on the same cation may be covalently connected to each other to form a substituted or unsubstituted ring or ring system.

According to an embodiment, any one of R¹, R², R³ and R⁴ is independently selected from C1 to C4, preferably C1 to C3 and most preferably C1 to C2 aliphatic substituents wherein any one, several or all hydrogens in said substituent may be replaced by halogen and wherein two or more of substituents present on the same cation may be covalently connected to each other to form a substituted or unsubstituted ring or ring system.

According to an embodiment, any one of R¹, R², R³ and R⁴ is independently selected from C1 to C10 alkyl, C2 to C10 alkenyl and C2 to C10 alkynyl, wherein said alkyl, alkenyl and alkynyl, if they comprise 3 or more carbons, may be linear, branched or cyclic, and wherein several or all hydrogens in said substituent may be replaced by halogen.

According to an embodiment, any one of R¹, R², R³ and R⁴ is independently selected from C1 to C8 alkyl, C2 to C8 alkenyl and C2 to C8 alkynyl, wherein said alkyl, alkenyl and alkynyl, if they comprise 3 or more carbons, may be linear, branched or cyclic, and wherein several or all hydrogens in said substituent may be replaced by halogen.

According to an embodiment, any one of R¹, R², R³ and R⁴ is independently selected from C1 to C6 alkyl, C2 to C6 alkenyl and C2 to C6 alkynyl, wherein said alkyl, alkenyl and alkynyl, if they comprise 3 or more carbons, may be linear, branched or cyclic, and wherein several or all hydrogens in said substituent may be replaced by halogen.

According to an embodiment, any one of R¹, R², R³ and R⁴ is independently selected from C1 to C4 alkyl, C2 to C4 alkenyl and C2 to C4 alkynyl, wherein said alkyl, alkenyl and alkynyl, if they comprise 3 or more carbons, may be linear, branched or cyclic, and wherein several or all hydrogens in said substituent may be replaced by halogen.

According to an embodiment, any one of R¹, R², R³ and R⁴ is independently selected from C1 to C3, preferably C1 to C2 alkyl, C2 to C3, preferably C2 alkenyl and C2 to C3, preferably C2 alkynyl, wherein said alkyl, alkenyl and alkynyl, if they comprise 3 or more carbons, may be linear, branched or cyclic, and wherein several or all hydrogens in said substituent may be replaced by halogen.

According to an embodiment, any one of R¹, R², R³ and R⁴ is independently selected from C1 to C4, more preferably C1 to C3 and even more preferably C1 to C2 alkyl. Most preferably, any one of R¹, R², R³ and R⁴ are methyl. Again, said alkyl may be completely or partially halogenated.

According to an embodiment, A and B is a monovalent or bivalent cation, respectively, selected from substituted and unsubstituted C5 to C6 rings comprising one, two or more nitrogen heteroatoms, wherein one (for A) or two (for B) of said nitrogen atoms is/are positively charged. Substituents of such rings may be selected from halogen and from C1 to C4 alkyls, C2 to C4 alkenyls and C2 to C4 alkynyls as defined above, preferably from C1 to C3 alkyls, C3 alkenyls and C3 alkynyls as defined above. Said ring may comprise further heteroatoms, which may replace one or more carbons in said ring, in particular, heteroatoms may be selected from O, N and S. Bivalent organic cations B comprising two positively charged ring N-atoms are exemplified, for example, by the compound of formula (10) above. Such rings may be aromatic or aliphatic.

A and B may also comprise a ring system comprising two or more rings, at least one of which being from substituted and unsubstituted C5 to C6 ring as defined as above. The elliptically drawn circle in the compound of formulae (10) may also represent a ring system comprising, for example, two or more rings, but preferably two rings. Also if A comprises two rings, further ring heteroatoms may be present, which are preferably not charged, for example.

According to an embodiment, however, the organic cations A and B comprise one (for A), two (for B) or more nitrogen atom(s) but is free of any O or S or any other heteroatom, with the exception of halogens, which may substitute one or more hydrogen atoms in cation A and/or B.

A preferably comprises one positively charged nitrogen atom. B preferably comprises two positively charged nitrogen atoms.

A and B may be selected from the exemplary rings or ring systems of formulae (30) and (31) (for A) and from (32) to (34) (for B) below: 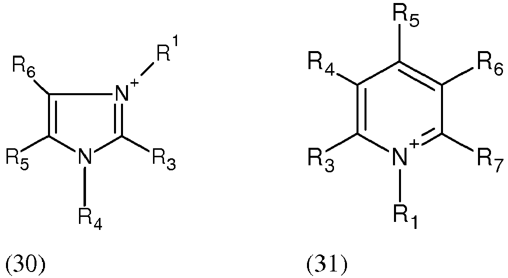 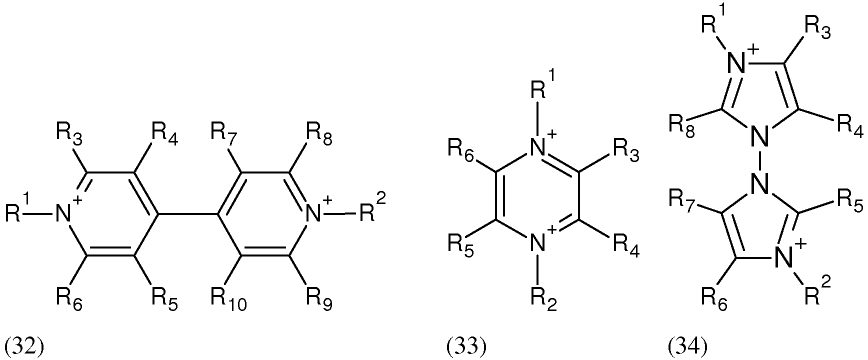 in which R¹ and R² are, independently, as defined above, and R₃, R₄, R₅, R₆, R₇, R₈, R₉ and R₁₀ are independently selected from H, halogen and substituents as defined above for R¹ to R⁴. Preferably, R₃-R₁₀ are selected from H and halogen, most preferably H.

In the organic cations A and B, hydrogens may be substituted by halogens, such as F, Cl, I, and Br, preferably F or Cl. Such a substitution is expected to reduce the hygroscopic properties of the perovskite layer or layers and is thus considered advantageous for the purpose of the present specification.

In the methods of the invention, the perovskite layer may be applied by any one or more selected from drop casting, spin-coating, dip-coating and spray-coating, for example.

According to an embodiment, the solar cell and/or heterojunction of the invention comprises two or more successive organic-inorganic perovskite layers, wherein said successive perovskite layers may be composed identically or wherein two or more of said layers may have a different molecular structure and/or composition. In this way, the different functions of sensitizing and/or hole transporting which are preferably achieved by the perovskite layers may be optimized and/or fine-tuned. In particular, the perovskite layer that is in contact with the scaffold structure (if a protective layer is provided (e.g. by ALD) on the scaffold structure: in contact with said protective layer), is preferably optimized with respect to its properties as a sensitizer. On the other hand, the perovskite layer or layers that is in contact with the counter electrode (or, if a protective layer is applied between the perovskite layer and the counter electrode: in contact with said perovskite layer) is preferably optimized with respect to its properties as a hole transporting material, in particular if another hole transporting material is absent, such as an organic hole transporting material.

If there are several, different perovskite layers, the different perovskite structures may be of a different composition. Any one or more of A, B, M, N or X in the structures of formulae (I) to (IX) may be changed in order to provide a different perovskite layer having different properties, as desired. In particular, A, B, M, N or X may be changed in a subsequent layer, in order to adjust the bandgaps of the material. Different layers comprising different perovskite structures, but preferably still within the general formulae (I) to (IX), may in particular be useful to optimize a respective layer to its function (sensitizer or hole conductor).

The solar cell of the invention preferably comprises a counter electrode. The counter electrode faces the perovskite towards the inside of the cell, and for example to a substrate towards (in direction of) the outside of the cell, if such substrate is present. The counter electrode generally comprises a catalytically active material, suitable to provide electrons and/or fill holes towards the inside of the device. The counter electrode may thus comprise one or more materials selected from (the group consisting of) Pt, Au, Ni, Cu, Ag, In, Ru, Pd, Rh, Ir, Os, C, conductive polymer and a combination of two or more of the aforementioned, for example. Conductive polymers may be selected from polymers comprising polyaniline, polypyrrole, polythiophene, polybenzene, polyethylenedioxythiophene, polypropylenedioxythiophene, polyacetylene, and combinations of two or more of the aforementioned, for example.

Of course, if there is a protective layer as discussed below between the counter electrode and the outermost perovskite layer, the counter electrode faces, towards the inside of the cell, said protective layer, which protective layer in turn faces, towards the inside of the cell, said perovskite layer, or a hole conductor layer, is such a layer is present.

The counter electrode may be applied as is conventional, for example by thermal evaporation of the counter electrode material onto the perovskite layer.

The counter electrode is preferably connected to a current collector, which is then is connected to the external circuit, as the conductive support on the other, opposed side of the device. As on the opposed side of the device, a conductive support such as conductive glass or plastic may be electrically connected to the counter electrode. In this case, the device has two opposed support or protective layers, which encase the solar cell, for example.

The solar cell of the invention is preferably a solid state solar cell. By avoiding an electrolyte, the disadvantages of electrolytes, such as loss due to solvent evaporation, electrolyte leakage, disadvantages associated with the use of redox shuttles, for example, can be avoided.

According to an embodiment, the solar cell and/or heterojunction of the invention cell lacks and/or is substantially or totally free of a separate, non-perovskite hole transporting material layer between said perovskite layer and said counter electrode. Preferably, the entire device is substantially free of a substantially organic charge (and/or hole) transporting material and/or free of an organic hole transport layer. By "organic hole transporting material", "organic charge transporting material", and the like, is meant any material or composition comprising an organic compound, wherein charges are transported by electron or hole movement (electronic motion) across said organic compound, said electronic compound being conductive. Organic hole transport materials are different from electrolytes in which charges are transported by diffusion of molecules.

It is surprising that a device lacking a non-perovskite hole transport layer is functional. Typically, solid state, sensitizer-based solar cells use a substantially organic hole transporting material in order to remove holes from the sensitizer and/or provide new electrons from the counter electrode to the sensitizer. The solar cell of the invention may and thus function without such an organic charge transporting material layer. A prominent example of an organic hole transporting material that is frequently used in prior art solid state solar cells is 2,2',7,7'-tetrakis(N,N-di-methoxyphenyamine)-9,9'-spirobifluorene (Spiro-MeOTAD). Preferably, the solar cell of the invention lack and/or is free of Spiro-MeOTAD. In W02007107961, a liquid organic hole conductor is disclosed. Preferably, the solar cell of the invention lacks and/or is free of a liquid hole conductor as disclosed in WO2007107961.

According to an embodiment, said counter electrode and/or metal layer is in direct contact with said perovskite layer and/or not separated by any further layer or medium from said perovskite layer. However, this does not exclude the possibility of a metal oxide protective layer of up to 1.5 nm thickness, which may be provided between said counter electrode and said perovskite layer, as specified elsewhere in this specification. Preferably, said counter electrode and/or metal layer is in direct electric contact with said perovskite layer, wherein electrons move from the counter electrode to the perovskite material, optionally across said protective layer.

Furthermore, while a non-perovskite, for example an organic hole transporting material may be absent in the device, the invention also encompasses solar cells in which a hole transport material, for example an inorganic hole transport layer or an organic hole transport layer comprising a material as defined and/ specified above, is present. An organic or inorganic hole transport material, if present, is preferably provided between the perovskite layer or layers and the counter electrode. If there are more than one perovskite layers, an inorganic and/or organic hole transporting material is preferably provided between the outermost perovskite layer and the counter electrode. In accordance with this embodiment, the organic or inorganic hole transport material is preferably a non-perovskite hole transport material.

It is noted that the term "organic" in expressions "organic hole transport material", "organic hole transport layer", "organic charge transport material" and the like does not exclude the presence of further components. Further components may be selected from (a) one or more dopants, (b) one or more solvents, (c) one or more other additives such as ionic compounds, and (c) combinations of the aforementioned components, for example. In the organic charge transport material, such further components may be present in amounts of 0-30wt.%, 0-20wt.%, 0-10wt.%, most preferably 0-5wt.%.

According to an embodiment, the solar cell and/or heterojunction of the invention comprises a metal oxide layer comprising a material selected from Mg-oxide, Hf-oxide, Ga-oxide, In-oxide, Nb-oxide, Ti-oxide, Ta-oxide, Y-oxide and Zr-oxide and having a thickness of not more than 1.5 nm, more preferably not more than 1 nm. Ga-oxide is preferred. Said metal oxide layer is in particular "buffer layer", also referred to as a "protective layer", which reduces or prevents recombination of photo generated electrons with the perovskite material, for example.

According to an embodiment, of the solar cell and/or heterojunction of the invention said metal oxide layer is a buffer layer and is provided on said scaffold structure by atomic layer deposition (ALD). Preferably, 2 to 7, preferably 3 to 5 and most preferably about 4 layers are deposited by ALD so as to provide said protective layer. Accordingly, said metal oxide layer is preferably a metal oxide multilayer.

Preferably, said metal oxide layer has a thickness of 1.5 nanometer (nm) or less (≤), preferably < 1.2 nm and most preferably ≤ 1 nm. According to an embodiment, said metal oxide layer has a thickness of 0.2 to 0.8 nm, preferably 0.3 to 0.7 nm, most preferably 0.4 to 0.6 nm.

The thickness of the metal oxide layer is preferably such that a tunneling of the electrons of the photo-excited perovskite into the conducting support layer and/or the scaffold structure is still possible. Tunneling is only possible if a certain thickness of the layer is not exceeded. In this case, electrons can go through the metal oxide layer, as they are not or only to a minor or acceptable extent prevented from transferring to the semiconductor material.

The protective layer is preferably as is disclosed in the pending international application PCT/IB2011/055550, filed on December 8, 2011, which is entirely incorporated herein by reference.

The solar cell of the invention may comprise 0, 1, two or even more protective layers selected independently from protective layers as defined above. According to an embodiment, the protective layer is provided between the scaffold structure and the perovskite. If there are more than one perovskite layers, the protective layer is preferably provided between the scaffold layer and the innermost perovskite layer. In case there are several perovskite layers in the device of the invention, the innermost perovskite layer is the one that is closest to the scaffold structure and/or farthest from the counter electrode; and the outermost perovskite layer is the layer that is farthest from the scaffold structure and closest to the counter electrode.

In accordance with an embodiment, a protective layer is provided between the perovskite layer and the counter electrode. If there are several perovskite layers, the protective layer is preferably provided between the outermost perovskite layer and the counter electrode. In other words, the counter electrode is either directly in contact with the (outermost) perovskite layer or with the protective layer towards the inside of the cell. In the latter case, the protective layer is in contact with the (outermost) perovskite layer.

Schematically, the present solar cell preferably comprises and/or consists of the following layers:
(2) conductive support and/or charge collector;
(3) scaffold structure;
   (i) optional protective layer;
(4) perovskite layer;
(4.1-4.n) optional n further perovskite layers, n being an integer of 1 to 10;
   (ii) optional hole conductor layer;
   (iii) optional protective layer;
(5) counter electrode.

The method of the invention comprises the step of applying one or more organic-inorganic perovskite layer on said scaffold structure. The perovskite layer may be applied by any suitable process. According to an embodiment, the one or more perovskite layers are applied by any one or a combination of drop costing, spin-coating, dip-coating and spray-coating.

According to an embodiment, the method of the invention comprises, consists essentially of or consists of the steps of the steps of providing a conducting support layer on which a surface-increasing scaffold structure is provided; applying one or more organic-inorganic perovskite layer on said scaffold structure; and, applying a counter electrode. Preferably, these steps are conducted in this order, with further or other steps being conducted before, after or within these steps without changing the order of the steps.

According to a preferred embodiment of the methods of the invention, said counter electrode is applied on said perovskite layer, or, if there are several such layers, on the outermost of said perovskite layers. If a hole conducting material used (for example an organic or inorganic) the latter is preferably provided between said outermost perovskite layer and said counter electrode. In this case, the methods of the invention comprise the step of applying a counter electrode on said hole conductor layer.

According to an embodiment, the method of the invention comprises one or more steps of applying one or more protective layers, in accordance with indications given elsewhere in this specification with respect to protective layers.

Figure 1A shows an exemplary solar cell 1 of the invention, in which 2 represents a conductive support, which may be an FTO glass as shown, 3 represents the scaffold structure, which, in Fig. 1A is indicated to be made from TiO₂, 4 represents the perovskite layer and 5 is the counter electrode, which may exemplary be made from a metal, as shown in Fig. 1A.

The present invention will now be illustrated by way of examples. These examples do not limit the scope of this invention, which is defined by the appended claims.

### Examples:

### CH3NH2I synthesis

CH₃NH₃I was synthesized by reacting 30 mL methylamine (40% in methanol, TCI) and 32.3 mL of hydroiodic acid (57 wt% in water, Aldrich) in a 250 mL round bottomed flask at 0 °C for 2 h with stirring. The precipitate was recovered by putting the clear solution on a roti-vapor and carefully removed the solvents at 50 °C. The yellowish raw product, methylammonium iodide (CH₃NH₃I), was washed with diethyl ether by stirring the solution for 30 min, which was repeated three times, and then finally recrystallized from a mixed solvent of diethyl ether and ethanol. After filtration, the solid was collected and dried at 60 °C in vacuum oven for 24 h.

### Synthesis and purification of TiO₂ nanosheets

The synthesis of the nanosheets was followed a typical experimental procedure³¹. Ti(OBu)₄ (10 mL, 98%) and hydrofluoric acid (0.8 mL, 47%) solution mixed in a 150 mL dried Teflonautoclave which was kept at 180°C for 24 h to yield well-defined rectangular sheet-like structures with a side length of 30 nm and a thickness of 7 nm. After the reaction was cooled to room temperature, the white powder was separated by high-speed centrifugation and washed with ethanol followed by distilled water for several times.

*Caution:* Hydrofluoric acid is extremely corrosive and a contact poison, it should be handled with extreme care! Hydrofluoric acid solution is stored in Teflon containers in use.

### Solar cell fabrication

Thin dense TiO₂ layer of ∼100 nm thickness was deposited onto a SnO₂:F conducting glass substrate (15Ω/cm, Pilkington) by spray pyrolysis method ³². The deposition temperature of TiO₂ compact layer was 450 °C. Nanopores TiO₂ film ( ∼ 0.5 µm thick) was prepared by spin coating method onto this substrate using the TiO₂ nanosheets with 001 dominant facets. The TiO₂ layer was annealed at 500 °C for 30 min in air. The substrate was immersed in 40 mM TiCl₄ aqueous solutions for 30 min at 70 °C and washed with distilled water and ethanol, followed by annealing at 500 °C for 30 min in air.

The synthesis of CH₃NH₃PbI₃ on the TiO₂ surface was carried out by dropping on the TiO₂ film a 40 wt% precursor solution of CH₃NH₃I and PbI₂ in γ-butyrolactone and film formation by spin coating (2000 rpm, 30 sec) in the glove box.

The film coated on the TiO₂ changed its color with drying at room temperature, indicating the formation of CH₃NH₃PbI₃ in the solid state. The CH₃NH₃PbI₃ film was annealed under argon for 15min at 100°C.

Finally the counter electrode was deposited by thermal evaporation of gold under a pressure of 5×10⁻⁵ Torr. The active area was 0.12 cm². After the preparation, the cells were allowed to expose in air.

### Photovoltaic Characterization

Photovoltaic measurements employed an AM 1.5 solar simulator equipped with a 450W xenon lamp (Model No. 81172, Oriel). Its power output was adjusted to match AM 1.5 global sunlight (100 mW/cm²) by using a reference Si photodiode equipped with an IR-cutoff filter (KG-3, Schott) in order to reduce the mismatch between the simulated light and AM 1.5 (in the region of 350-750 nm) to less than 2% with measurements verified at two PV calibration laboratories [ISE (Germany), NREL (USA)]. I-V curves were obtained by applying an external bias to the cell and measuring the generated photocurrent with a Keithley model 2400 digital source meter. The voltage step and delay time of photocurrent were 10 mV and 40 ms, respectively. A similar data acquisition system was used to determine the monochromatic incident photon- to-electric current conversion efficiency. Under full computer control, light from a 300 W xenon lamp (ILC Technology, U.S.A.) was focused through a Gemini-180 double monochromator (Jobin Yvon Ltd., U.K.) onto the photovoltaic cell under test. The monochromator was incremented through the visible spectrum to generate the IPCE (λ) as defined by IPCE (λ)) = 12400(Jsc/λϕ), where λ is the wavelength, Jsc is short-circuit photocurrent density (mA cm⁻²), and ϕ is the incident radiative flux (mW cm⁻²). Photovoltaic performance was measured by using a metal mask with an aperture area of 0.49 cm².

The cross section of the device was measured by Zeiss Jemini FEG-SEM, using 5kV with magnification of 250KX.

### Results

The synthesis of CH₃NH₃PbI₃ on the TiO₂ surface was carried out by dropping on the TiO₂ film a 40 wt% precursor solution of CH₃NH₃I and PbI₂ in γ-butyrolactone and film formation by spin coating. CH₃NH₃I was synthesized from HI by reaction with 40% methylamine in methanol solution and recrystallization. The film coated on the TiO₂ changed its color with drying at room temperature, indicating the formation of CH₃NH₃PbI₃ in the solid state.

Figures 1A and 1B present a scheme of the device structure and its energy level diagram. The conduction and valence bands of the CH₃NH₃PbI₃ permit electron injection and hole transportation to the TiO₂ and the gold respectively. The bottom layer is composed of compact TiO₂ and TiO₂ nanosheets with exposed (001) facets layers acting as electron collectors. The light is absorbed by CH₃NH₃PbI₃ thin film, which was made by spin coating technique. A gold contact was eveporated on top of the CH₃NH₃PbI₃ thin film.

Figure 2 shows high resolution scaning electron microscopy (HR-SEM) image of the cross section of the solar cell. Since the organo lead halide perovskite is depositied as thin layer on top of the TiO₂ nanosheets it is hard to distinguish between the TiO₂ and the perovskite.

Figure 3A exhibits J-V characteristics of the CH₃NH₃PbI₃ heterojunction photovoltaic cell under 1 sun illumination. The organo lead perovskite heterojunction solar cell produces an open-circuit voltage (V_{oc}) of 0.631 V, a short circuit current density (J_{sc}) of 16.1mA cm⁻² and a fill factor of 57% corresponding to a power conversion efficiency (PCE) of 5.5% under 1 sun intensity (Table 1). It is important to note that the power conversion effiency under 10% sun was 7.28% with J_{sc} of 2.14 mA cm⁻², a fill factor of 62% and Voc of 0.565 V.

The incident photon to current conversion efficiency (IPCE) specifies the ratio of extracted electrons to incident photons at a given wavelength. The IPCE spectrum (Figure 3B) is plotted as a function of wavelength of the light. The solid state CH₃NH₃PbI₃ heterojunction solar cell shows a good response from the visible through 800nm wavelength, the IPCE spectrum is reaching its maximum of 90% at wavelength of 400nm until 540nm while it is decreasing till 780nm wavelength. Integration of the IPCE spectrum over the AM1.5 solar emission yields a photocurrent density of 16.2 mA/cm², in good agreement with the measured values.

**Table 1: photovoltaic characteristic of perovskite cell**

| Sun Intensity | Jsc (mA/cm2) | Voc (mV) | FF | η (%) |
|---|---|---|---|---|
| 10 | 2.1 | 565.8 | 0.62 | 7.28 |
| 100 | 16.1 | 631.6 | 0.57 | 5.5 |

### Conclusion

In summary the organo lead perovskite act as an efficient sensitizer and hole transport material by that we are eliminate the use of hole conductor. The perovskite is stable at ambient air and it can be deposited by low cost technique. This finding opens the way for high efficiency low cost photovoltaic cells.

### References:

¹ Huynh, W. U., Dittmer, J. J.; Alivisatos, A P ,Science, 2002,295,2425.
² I. Gur, N. A. Fromer, M. I Geier, A. P Alivisatos, Science, 2005, 310, 462*.*
³ W. J. E. Beek, M. M Wienk, R. A. J. Janssen, Adv. Func. Mater. 2006, 16, 1112.
⁴ J. M. Luther, M. Law, M. C. Beard, Q. Song, M. O. Reese, R. J. Ellingson, A. J. Nozik, Nano lett. 2008, 8, 3488.
⁵ W. Ma, J. M. Luther, H.Zheng, Y.Wu, A. P. Alivisatos, Nano lett. 2009, 9,1699.
⁶ R. Plass, S.Pelet, J. Krueger, M. Grätzel, U. Bach, J. Phys. Chem. B, 2002, 106, 7578.
⁷ B. Sun, A. T. Findikoglu, M. Sykora, D. J. Werder, V. I. Klimov, Nano lett. 2009, 9, 1235.
⁸ J. M. Luther, M. Law, Q. Song, C. L. Perkins, M. C. Beard, A. J. Nozik, ACS Nano, 2008, 2,271.
⁹ S. Zhang, P. W. Cyr, S. A. McDonald, G. Konstantatos, E. H. Sargent, Appl. Phys. Lett. 2005, 87, 233101.
¹⁰ B.-R. Hyun, Y.-W. Zhong, A. C. Bartnik, L. Sun, H. D. Abru 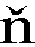 a, F. W. Wise, J. D. Goodreau, J. R. Matthews, T. M. Leslie, F. Borrelli, *ACS Nano,* **2008**, *2*, 2206.
¹¹D. Ratan, T. Jiang, D. A. Barkhouse, W. Xihua, G. P.-A. Andras, B. Lukasz, L. Larissa, E. H. Sargent, J. Amer. Chem. Soc., 2010, 132, 5952.
¹² J. M. Luther, J. Gao, M. T. Lloyd, O. E. Semonin, M. C. Beard, A. J. Nozik, Adv. Mater. 2010, 22, 3704.
¹³ A. G. Pattantyus-Abraham, I. J. Kramer, A. R. Barkhouse, X. Wang, G. Konstantatos, R. Debnath, L. Levina, I. Raabe, M. K. Nazeeruddin, M. Gratzel, E. H. Sargent, ACS Nano. 2010, 4(6), 3374.
¹⁴ H. Liu, J. Tang, I. J. Kramer, R. Debnath, G. I. Koleilat, X. Wang, A. Fisher, R. Li, L. Brzozowski, L. Levina, E. H. Sargent, Adv. Mater. 2011, 23, 3832.
¹⁵ J. Gao, J. M. Luther, O. E. Semonin, R. J. Ellingson, A. J. Nozik, M. C. Beard, Nano Lett., 2011, 11 (3), pp 1002.
¹⁶ J. Gao, C. L. Perkins, J. M. Luther, M. C. Hanna, H.Y. Chen, O. E. Semonin, A. J. Nozik, R. J. Ellingson, M. C. Beard, Nano Lett., 2011, 11 (8), pp 3263.
¹⁷ D. A. R. Barkhouse, R. Debnath, I. J. Kramer, D. Zhitomirsky, A. G. Pattantyus-Abraham, L. Levina, L. Etgar, M. Grätzel, Edward H. Sargent, Adv. Mater., 2011, 23, 3134.
¹⁸ X. Wang, G. I. Koleilat, J. Tang, H. Liu, I. J. Kramer, R. Debnath, L. Brzozowski, D. A. R. Barkhouse, L. Levina, S. Hoogland, E. H. Sargent, Nature photonics, 2011, 5, 480.
¹⁹ K. S. Leschikies, T. J. Beatty, M. S. Kang, D. J. Norris, E. S. Aydil, ACS Nano, 2009, 3(11), 3638.
²⁰ Lioz Etgar, Wei Zhang, Stefanie Gabriel, Stephen G. Hickey, Md K. Nazeeruddin , Alexander Eychmüller, Bin Liu, Michael Grätzel. Advanced Materials, 2012, 24(16), 2202-2206.
²¹ Lioz Etgar, Thomas Moehl, Stefanie Tscharntke, Stephen G. Hickey, Alexander Eychmüller and Michael Grätzel. ACS Nano, 6 (4), 3092-3099, 2012.
²² F. W. Wise, Acc. Chem. Res. 2000, 33, 773.
²³ J. B. Sambur, T. Novet, B. A. Parkinson, Science, 2010, 330, 63.
²⁴ Akihiro Kojima, Masashi Ikegami, Kenjiro Teshima, and Tsutomu Miyasaka, Chem. Lett. 2012,41,397.
²⁵ C. I. Covaliu, L. C. Chioaru, L. Craciun, O. Oprea, I. Jitaru, Optoelectronics and advanced materials , 5 (10), 2011, 1097.
²⁶ C.R. Kagan, D. B. Mitzi, C. D. Dimitrakopoulos, Science 286, 945, 1999.
²⁷ D.B Mitzi, C.A. Feild, Z. Schlesinger, R.B. Laibowitz, J.Solid State Chem. 114, 159, 1995.
²⁸ Akihiro Kojima, Kenjiro Teshima, Yasuo Shirai, and Tsutomu Miyasaka, J.Am. Chem. Soc. 2009, 131, 6050-6051.
²⁹ Jeong-Hyoek Im, Jaehoon Chung , Seung-Joo Kim , Nam-Gyu Park, Nanoscale Research Letters, 2012, 7:353.
³⁰ Jeong-Hyeok Im, Chang-Ryul Lee, Jin-Wook Lee, Sang-Won Park and Nam-Gyu Park, nanoscale, 2011, 3, 4088.
³¹ X. Han, Q. Kuang, M. Jin, Z. Xie, L. Zheng, J. Am. Chem. Soc., 2009, 131 (9), 3152.
³² Moon, S. J.; Yum, J. H.; Humphry-Baker, R.; Karlsson, K. M.; Hagberg, D. P.; Marinado, T.; Hagfeldt, A.; Sun, L. C.; Grätzel, M.; Nazeeruddin, M. K. J. Phys. Chem. C 2009, 113, 16816.

## Claims

1. A solid-state solar cell (1) comprising a conducting support layer (2) and a surface-increasing scaffold structure (3), wherein one or more organic-inorganic perovskite layer (4) is provided on said scaffold structure or on a protective layer that is optionally provided on said scaffold structure, and wherein a counter electrode and/or metal layer (5) is provided in electric contact with said perovskite layer.

2. The solar cell of claim 1, wherein said solar cell lacks a separate, non-perovskite hole transporting material layer between said perovskite layer and said counter electrode.

3. The solar cell of any one of the preceding claims, wherein said organic-inorganic perovskite layer (4) comprises a perovskite-structure of the formula (I), (II), (III), and/or (IV) below,
A₂MX₄ (I)
AMX₃ (II)
ANX₄ (III)
BMX₄ (IV)
wherein,
A is an organic, monovalent cation selected from primary, secondary, tertiary or quaternary organic ammonium compounds, including N-containing heterorings and ring systems, A having from 1 to 15 carbons and 1-20 heteroatoms;
B is an organic, bialent cation selected from primary, secondary, tertiary or quaternary organic ammonium compounds having from 1 to 15 carbons and 2-20 heteroatoms and having two positively charged nitrogen atoms;
M is a divalent metal cation selected from the group consisting of Cu²⁺, Ni²⁺, Co²⁺, Fe²⁺, Mn²⁺, Cᵣ²⁺, Pd²⁺, Cd²⁺, Ge²⁺, Sn²⁺, Pb²⁺, Eu²⁺, or Yb²⁺;
N is selected from the group of Bi³⁺ and Sb³⁺; and
the three or four X are independently selected from l⁻, Br⁻, I⁻, NCS⁻, CN⁻, and NCO⁻.

4. The solar cell of any one of the preceding claims, wherein said organic-inorganic perovskite layer (4) comprises a perovskite-structure of any one of the formulae (V), (VI), (VII), (VIII), (IX) and (X);
APbX₃ (V)
ASnX₃ (VI)
A₂PbX₄ (VII)
A₂SnX₄ (VIII)
BPbX₄ (IX)
BSnX₄ (X)
wherein A, B and X are as defined above.

5. The solar cell of any one of claims 3 and 4, wherein X is selected from Br⁻ and I⁻.

6. The solar cell of any one of claims 3 to 5, wherein A is a monovalent cation selected from any one of the compounds of formulae (1) to (8) below: 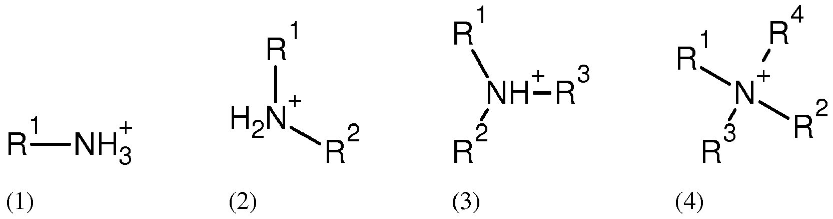 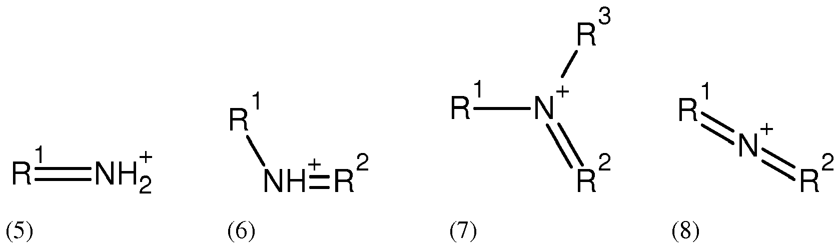 wherein,
any one of R¹, R², R³ and R⁴ is independently selected from C1 to C15 aliphatic and C4 to C15 aromatic substituents, wherein any one, several or all hydrogens in said substituent may be replaced by halogen and wherein, if there are two or more carbons, up to half of said carbons in said substituents may be replaced by a N, S or O heteroatom, and wherein, in any one of the compounds (2) to (8), the two or more of the substituents present may be covalently connected to each other to form a substituted or unsubstituted ring or ring system.

7. The solar cell of any one of claims 3 to 6, wherein B is a bivalent cation selected from any one of the compounds of formulae (9) and (10) below: 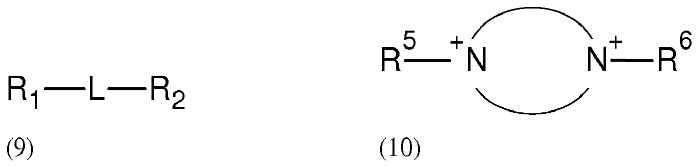 wherein,
in the compound of formula (9), L is an aliphatic or aromatic linker structure having 1 to 10 carbons, wherein any one, several or all hydrogens in said L may be replaced by halogen and wherein 0 to 5 carbons in said L may be replaced, independently, by a N, S or O heteroatom;
wherein the ring in compound (10) represents a aliphatic or aromatic ring or ring system comprising 4 to 15 carbons and 2 to 7 heteroatoms, including said two N-heteroatoms;
wherein any one of R₁ and R₂ is independently selected from any one of the substituents (20) to (25) below: 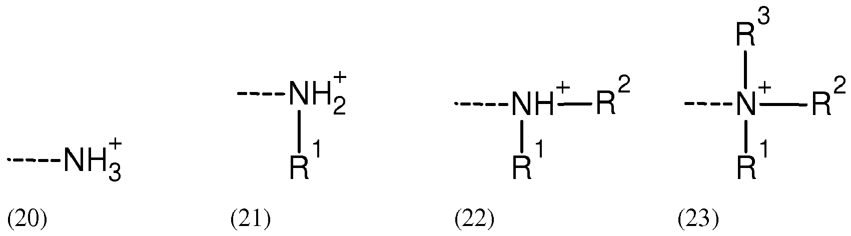 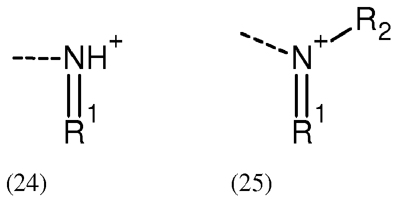 wherein the dotted line in the substituents (20) to (25) represents the bond by which said substituent is connected to the linker structure L;
wherein R¹, R², and R³ are independently as defined in Claim 6;
wherein R₁ and R₂, if they are both different from substituent (20), may be covalently connected to each other by way of their substituents R¹, R², and R³, as applicable, and wherein any one of R¹, R², and R³, if present, may be covalently connected to L or the ring structure of compound (10), independently from whether said substituent is present on R₁ or R₂;
and wherein, in the compound of formula (10), the circle containing said two positively charged nitrogen atoms represents an aromatic ring or ring system comprising 4 to 15 carbon atoms and 2 to 7 heteroatoms, wherein said nitrogen atoms are ring heteroatoms of said ring or ring system, and wherein R⁵ and R⁶ are independently selected from H and from substituents as R¹ to R⁴.

8. The solar cell of any one of the preceding claims, wherein said surface-increasing scaffold structure (3) is made from and/or comprises one selected from the group consisting of a semiconductor material, a conducting material and a non-conducting material.

9. The solar cell of any one of the preceding claims, wherein the surface area per gram ratio of said scaffold structure (3) is in the range of 20 to 200 m²/g, preferably 30 to 150 m²/g, and most preferably 60 to 120 m²/g.

10. The solar cell of any one of the preceding claims, wherein said scaffold structure (3) comprises and/or is prepared from nanoparticles, such as nanosheets.

11. The solar cell of any one of the preceding claims, wherein said scaffold structure (3) is nanostructured and/or nanoporous.

12. The solar cell of any one of the preceding claims, further comprising a metal oxide layer comprising a material selected from Mg-oxide, Hf-oxide, Ga-oxide, In-oxide, Nb-oxide, Ti-oxide, Ta-oxide, Y-oxide and Zr-oxide and having a thickness of not more than1 nm.

13. The solar cell of any one of the preceding claims, comprising two or more successive organic-inorganic perovskite layers (4), wherein said successive perovskite layers may be composed identically or wherein two or more of said layers may have a different molecular structure and/or composition.

14. A solid state heterojunction comprising a conducting support layer (2), on which a surface-increasing scaffold structure (3) is provided, wherein an organic-inorganic perovskite layer (4) is provided on said scaffold structure.

15. A method of preparing a solid state solar cell, the method comprising the steps of:
- providing a conducting support layer (2) on which a surface-increasing scaffold structure (3) is provided;
- applying one or more organic-inorganic perovskite layer (4) on said scaffold structure or on a protective layer that may be present on said scaffold structure by any one or more selected from spin-coating, dip-coating and spray-coating; and,
- applying a counter electrode.
